# EUROPEAN PATENT APPLICATION

(11) **EP 0 601 509 A1**
(43) Date of publication of application: **15.06.1994**
(21) Application number: 93119603.4
(22) Date of filing: 06.12.1993
(51) Int. Cl.: H01L 23/485

(54) **Semiconductor devices and method of manufacturing the same**

(30) Priority: 07.12.1992 JP 351108/92; 07.12.1992 JP 351109/92
(71) Applicant: NIKKO KYODO CO., LTD., Minato-ku Tokyo (JP)
(72) Inventor: Irumada, Shuichi, c/o Nikko Kyodo Co., Ltd., Kitaibaraki-shi, Ibaraki-ken (JP); Fukuyo, Hideaki, c/o Nikko Kyodo Co., Ltd., Kitaibaraki-shi, Ibaraki-ken (JP); Ohhashi, Tateo, c/o Nikko Kyodo Co., Ltd., Kitaibaraki-shi, Ibaraki-ken (JP); Sawada, Susumu, c/o Nikko Kyodo Co., Ltd., Kitaibaraki-shi, Ibaraki-ken (JP)
(74) Representative: Schwan, Gerhard, Dipl.-Ing.

(57) **Abstract**

Semiconductor devices provided with thin film wirings formed from a copper alloy containing 0.02-20 at% aluminum or 0.02-20 at% silicon or both. Thin film wirings of this composition can form a surface oxide film upon heat treatment at 500°C or under. The oxide film functions as a barrier layer against oxidation as Al or Si or both from the bulk portion is diffused and concentrated in the oxide film. The bulk portion of the wirings is close to pure copper in structure because Al or Si or both are diffused into the surface oxide film. It thus maintains the low resistivity, EM resistance, and SM resistance inherent to copper. The copper alloy wirings so formed, with a resistivity of 10 µΩ·cm or less and moreover with oxidation resistance, are capable of catching up with the future increases in the degree of integration of semiconductor devices. There are also provided a sputter target for forming thin film wirings which consists of 0.02 to 20 atomic percent of aluminum or 0.02 to 20 atomic percent of silicon or both and the balance copper and a method of manufacturing semiconductor devices comprising of forming thin film wirings on a substrate by sputtering the sputter target followed by forming an oxide film on the thin film wiring surface.

## Description

### [FIELD OF THE INVENTION]

This invention relates to semiconductor devices having on their substrates thin film wirings formed from a copper alloy containing a small quantity of aluminum and/or silicon and also to a method of manufacturing them. The semiconductor devices according to the present invention include copper wirings having a specific resistivity of 10 µΩ·cm or less and excellent oxidation resistance, and are capable of meeting future demand for semiconductor integrated circuits and the like with greater degrees of integration than heretofore. This invention also relates to sputter targets for forming such thin film wirings which consists of a copper alloy containing a small quantity of aluminum and/or silicon and further to a method of manufacturing semiconductor devices by use of the targets.

### [BACKGROUND OF THE INVENTION]

Aluminum alloys containing silicon or the like have hitherto been used in forming wirings for the integrated circuits of semiconductor devices and the like. As increasing degrees of integration accompanied with smaller and finer the elements and interconnections, problems of increased wiring resistance and electromigration (EM) come to the fore. Also, a so-called stress migration (SM) problem arises from the difference in thermal expansion between the wiring material and the substrate material that becomes more pronounced as the tendency is toward higher integration.

Copper is promising as a wiring material for the coming generation because it has lower resistivity than aluminum and appears to be more resistant to EM and SM. However, it is highly susceptible to oxidation and readily reactive with a film of Si and SiO₂. These weak points have hampered the practical use of copper wirings.

Some attempts have thus far been made to improve the oxidation resistance of copper wirings by forming a barrier layer on the surface of copper wirings to prevent the diffusion of oxygen into copper and keep copper itself from diffusing into the Si or SiO₂ film. One such method is disclosed in the "Previous Theses for Lectures at the 49th Academic Lecture Meeting of the Japan Applied Physics Society" Autumn, 1988, Vol. 2 (1988), p.434, 5p-T-4. The method uses a mosaic target consisting of Cu and Ti placed thereon for sputtering, and the resulting Cu-Ti film is heat treated in nitrogen gas at 800 °C to form a titanium nitride layer, whereby copper wirings are made which is excellent in oxidation resistance and moreover show low specific resistivity.

However, the titanium nitride film is thermodynamically not always stable in oxygen atmospheres. In order to form copper wirings provided with such a titanium nitride layer on the surface by self-alignment, it is necessary to incorporate the heat treatment at 800 °C into the process for manufacturing semiconductor elements. Before the successful incorporation of the treatment, the following difficulties must be overcome:
(1) The temperatures that the p-n junctions usually formed in semiconductor devices can withstand are up to approximately 750 °C, and the heat treatment temperature of 800°C is exceedingly high for them.
(2) It is permitted to use, wherever possible, the existing materials as well as process being used for aluminum wired semiconductor devices. (For instance, the heat treatment temperature of 800 °C is too high for organic substances such as polyimides to be employed).
(3) There should be no major limitation to the choice of materials that are expected to vary with increasing degrees of integration.

Forming a barrier layer such as a titanium nitride layer at a relatively low temperature is possible if self-alignment is not a precondition. In that case, however, an increase in the number of process steps is inevitable.

### [OBJECT OF THE INVENTION]

The object of this invention is to establish a technique whereby the heat treatment to improve the oxidation resistance of copper wiring materials for semiconductor devices can be performed at a temperature of 500°C or under.

### [SUMMARY OF THE INVENTION]

In an effort to solve those problems of the prior art, we directed our attention to aluminum and silicon, both of which appeared to form thermodynamically stable, dense oxide films. Our extensive investigations have now led to the following findings upon which the present invention is predicated.
(1) By forming thin film wirings from a copper alloy containing 0.02 to 20 at% of aluminum and/or 0.02 to 20 at% silicon and then oxidizing them, an oxide film is formed in which Al and/or Si is diffused and concentrated in the vicinity of the surface of the wirings. This oxide film is excellently resistant to oxidation, and the bulk portion of the wirings are close to pure copper in structure because Al and/or Si is diffused out into the surface oxide film. This allows the bulk portion to maintain the low specific resistivity, EM resistance, and SM resistance inherent to copper. The copper alloy wirings thus formed have outstanding properties well capable of meeting the higher integration tendency, with a specific resistivity of 10 µΩ·cm or less and moreover oxidation resistance.
(2) Oxidation of the thin film wirings can be effected at a temperature of 500 °C or under.
(3) For the formation of the copper alloy thin film wirings, sputtering of a copper alloy target containing 0.02 to 20 atomic percent aluminum and/or 0.02 to 20 atomic percent silicon is the best method in view of the homogeneity of the resulting film and also of the productivity.

On the basis of the above findings, the present invention provides:
(1) a semiconductor device wherein thin film wirings formed on a substrate is consisted of a copper alloy which consists of 0.02 to 20 atomic percent of aluminum or 0.02 to 20 atomic percent of silicon or both and the balance copper and unavoidable impurities. The thin film wirings are characterized in that they have an oxide film layer of the copper alloy, especially a preferentially selected oxide layer of aluminum and/or silicon, formed on the surface. The copper alloy wirings are characterized by a specific resistivity of 10 µΩ·cm or less.
   The present invention also provides:
(2) a method of manufacturing semiconductor devices comprising the steps of forming thin film wirings on a substrate from a copper alloy consisting of 0.02 to 20 atomic percent aluminum and/or 0.02 to 20 atomic percent silicon and the balance copper and unavoidable impurities, and then heat treating the thin film wirings at or below 500°C, thereby forming an oxide film on the surface.
   The present invention further provides:
(3) a sputter target for forming thin film wirings of semiconductors which consists of 0.02 to 20 atomic percent of aluminum and/or 0.02 to 20 atomic percent of silicon and the balance copper and unavoidable impurities, and
(4) a method of manufacturing semiconductor devices comprising the steps of forming thin film wirings on a substrate by sputtering a sputter target of a copper alloy which consists of 0.02 to 20 atomic percent of aluminum and/or 0.02 to 20 atomic percent of silicon and the balance copper and unavoidable impurities, and then forming an oxide film on the thin film wiring surface.

### [BRIEF EXPLANATION OF THE DRAWINGS]

FIG. 1 shows the results of an analysis conducted by Auger electron spectroscopy (AES) of a vacuum annealed-oxidized film, in connection with Example 1-1, scanned in the depth direction from the film surface.

FIG. 2 shows the results of an analysis conducted by Auger electron spectroscopy (AES) of a vacuum annealed-oxidized film, in connection with Example 2-1, scanned in the depth direction from the film surface.

FIG. 3 shows the results of an analysis by AES of a film annealed in an N₂ gas at 450 °C, in connection with Example 2-2, scanned in the depth direction from the film surface.

FIG. 4 shows the results of an analysis by AES of a nitrided film, in connection with Comparative Example 2-2, scanned in the depth direction from the film surface.

FIG. 5 shows the results of an analysis by X-ray photo-electron spectroscopy (XPS) conducted in connection with Comparative Example 2-2.

### [DESCRIPTION OF EMBODIMENTS]

Thin film wirings formed on the substrate of a semiconductor device from a copper alloy containing 0.02 to 20 at% aluminum and/or 0.02 to 20 at% silicon readily form a surface oxide film upon heating at or below 500 °C . This oxide film is a stable, dense film in which Al and/or Si from the bulk portion of the wirings is diffused and concentrated with excellent oxidation resistance, and so it functions as a barrier layer. Meanwhile the bulk portion of the wirings from which Al and/or Si has diffused out into the surface oxide film becomes close to pure copper in structure. It can therefore adequately maintain the low resistivity and EM and SM resistance that copper possesses by nature. Since the copper alloy wirings so formed have a specific resistivity of 10 µΩ·cm or less and oxidation resistance, the semiconductor devices provided with the thin film wirings can catch up with future increases in the degree of integration.

The copper alloy thin film wirings containing 0.02 to 20 at% aluminum and/or 0.02 to 20 at% silicon are formed on a substrate by sputtering, vapor deposition, chemical vapor deposition (CVD), or other vapor-phase film forming technique.

In sputtering, for example, thin film wirings can be formed by sputtering either a copper alloy target of the above specified composition or a combination of an aluminum and/or silicon target and a copper target simultaneously. Vapor deposition is performed by heating a copper alloy evaporation source of the above composition. For CVD, suitable copper and aluminum and/or silicon compound are reacted in the vapor phase.

It is recommended to use a sputtering copper alloy target containing 0.02 to 20 at% aluminum and/or 0.02 to 20 at% silicon. Thin film wirings formed on the substrate by sputtering a sputter target of a copper alloy containing 0.02 to 20 at% aluminum and/or 0.02 to 20 at% silicon readily form a surface oxide film upon heating at or below 500 °C . As stated above, this oxide film is a stable, dense film in which Al and/or Si from the bulk portion of the wirings is diffused and concentrated. With excellent oxidation resistance, it functions as a barrier layer. Meanwhile the bulk portion of the wirings from which Al and/or Si has diffused out into the surface oxide film is close to pure copper in structure. It can therefore adequately maintain the low resistivity and EM and SM resistance that copper possesses by nature. Since the copper alloy wirings so formed have a resistivity of 10 µΩ·cm or less and oxidation resistance, they have excellent properties as a wiring material for the next generation capable of catching up with future increases in the degree of integration.

The copper alloy target containing 0.02 to 20 at% aluminum and/or 0.02 to 20 at% silicon may be made by a conventional target manufacturing method. For example, it can be made by casting molten copper to which a desired amount of aluminum and/or silicon has been added or by hot pressing a powder of such an alloy. Sputtering this copper alloy target forms thin film wirings on a substrate. Alternatively, an aluminum and/or silicon target and a copper target may be simultaneously sputtered to form thin film wirings as well.

The average Al and/or Si content in the thin film wiring material for semiconductor devices and a copper alloy target therefor is limited within the range of 0.02 to 20 at% each, because if the content is less than 0.02 at% there is no appreciable improvement in oxidation resistance and if it is more than 20 at% the resistivity exceeds the desirable limit of 10 µΩ·cm. Copper alloy wirings with a specific resistivity of over 10µΩ·cm are unusable as such for highly integrated semiconductor devices.

In order to reduce the residual stresses and lower the specific resistivity of the thin film wirings, it is desirable that they be annealed in a vacuum or inert atmosphere at a temperature between 300 and 500 °C . Depending on the composition of the wiring material used, the annealing alone may cause the residual oxygen present in a small amount in the atmosphere to oxidize the thin film wirings and form a desired oxide film layer. Especially when the material contains Al, mere annealing achieves the necessary oxidation effect.

Where the annealing does not produce an adequate oxidative action, oxidation heat treatment of the thin film wirings is done for complete oxidation. It is one of the important features of the present invention that the heat treatment can be carried out at or below 500°C . When the temperature exceeds 500 °C , the treatment begins to affect adversely the heat resistance of the p-n junctions of semiconductor devices. It can cause changes in properties of a low-dielectric-constant organic substance (e.g., a polyimide) that is used before or after the formation of the wiring material, peeling of the wirings due to the difference between the thermal expansion coefficients of the wiring material and the substrate material, or allowing the residual stresses to induce stress migration (SM). The atmosphere for the heat treatment may be vacuum or an inert gas atmosphere if it contains a trace amount of residual oxygen. Air atmosphere may be used as well. The oxidation treatment may, for example, be conducted under the following conditions:

| | |
|---|---|
| Temperature | 200-500 °C |
| Atmosphere | oxygen at 10⁻³-10 Pa or nitrogen at 1 atm. containing 1-200 ppm oxygen |
| Treating time | 10 min. - 2 hr. |

In this way an oxide film can be formed while diffusing and concentrating Al and/or Si near the surface of the wirings. The bulk portion of the wirings is almost pure copper because the Al and/or Si has diffused out into the surface, and can maintain the low specific resistivity (10µΩ ·cm or less), EM resistance, and SM resistance that copper originally possesses. Therefore, the semiconductor devices provided with these wirings are expected to come up satisfactorily with more and more integrated circuits of tomorrow.

### [EXAMPLES]

The invention is illustrated by the following examples and comparative examples, throughout which the thin film wirings for semiconductor devices were formed by sputtering using a sputtering copper alloy target containing 0.02 to 20 at% aluminum and/or 0.02 to 20 at% silicon under the conditions listed in Table 1.

**Table 1**

| Sputtering condition | |
|---|---|
| Target | 3 in. (flat plate type) |
| Electric power | 90 W |
| Ar pressure | 1 Pa |
| Substrate Temperature | Room temperature |
| Film thickness | 0.7µm |
| Substrate | SiO₂ coated glass |

The oxidation resistance tests referred to in the Examples were heat treatment tests conducted under the conditions given in Table 2.

**Table 2**

| Oxidation resistance test condition | |
|---|---|
| Heat treatment atmosphere | N₂-O₂ (1.4 ppm) mixed gas, 1 atm. |
| Heat treatment temperature | 450°C |
| Heat treatment time | 60 min |

### (Example 1-1: relatively much Al)

A wiring layer of a copper alloy with an Al content of 12.3 at% was formed on a substrate using a Cu-12.3 at% Al alloy target (bulk resistance: 9.8µΩ·cm). First, the film as formed (specific resistivity: 17.9 µΩ·cm) was subjected to an oxidation resistance test. The specific resistivity increased to 20.9 µΩ·cm, an undesirably high level, albeit the deterioration was not serious.

The film as formed was then heat treated (vacuum annealed) in a vacuum at 4× 10⁻⁴ Pa and at 400°C for one hour. The specific resistivity dropped to 9.8 µΩ·cm.

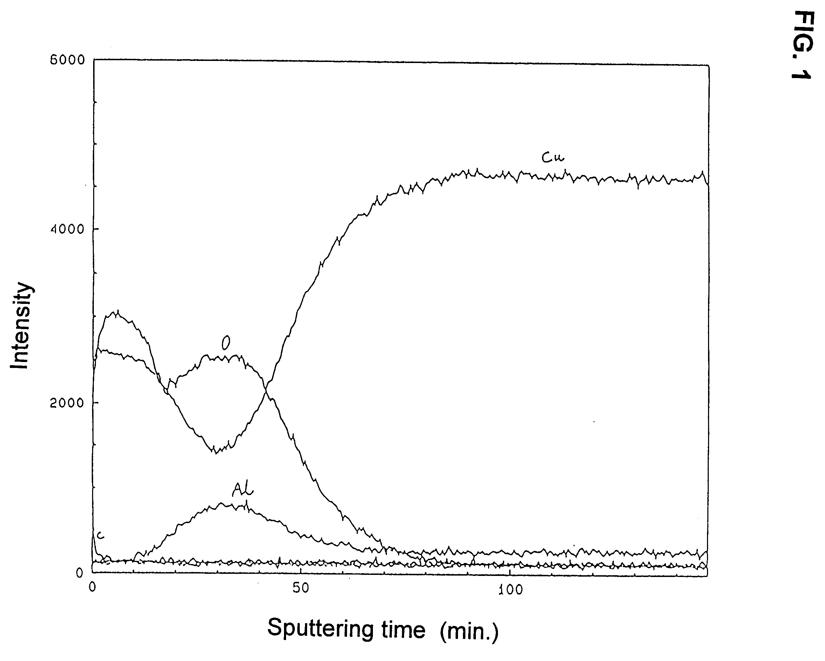

The vacuum annealed film was further heat treated (oxidized) in air at 450°C for one hour. The specific resistivity was not almost changed and was 9.9µΩ·cm. FIG. 1 shows the result of an analysis of the "vacuum annealed and oxidized" film by Auger electron spectroscopy (AES) scanned in the depth direction from the film surface. Diffusion of Al into the surface layer and the formation of an alloy oxide layer are observed. The little change in resistivity with the oxidation treatment suggests that the state of FIG. 1 had been realized only by the vacuum annealing.

Both the vacuum annealed film and the vacuum annealed and oxidized film were found to exhibit oxidation resistance under most severe conditions.

### (Example 1-2: small amount of Al)

A copper alloy wiring layer with an Al content of 0.24 at% was formed on a substrate using a Cu-0.24 at% Al alloy target (bulk resistance: 1.7µΩ·cm). The film as formed (specific resistivity: 3.2µΩ·cm) was heat treated (N₂ gas-annealed) in 1 atm. N₂ gas atmosphere at (a) 300°C and (b) 450 °C for one hour each. The resistivity values were (a) 2.8 and (b) 2.8 µΩ·cm, respectively.

The N₂ gas-annealed film (a) was evaluated by an oxidation resistance test, when it was found to possess oxidation resistance, with rather some decrease of the resistivity to 2.6µΩ·cm.

### (Example 2-1: relatively much Si)

A copper alloy wiring layer with an Si content of 13.5 at% was formed on a substrate using Cu-10.6 at% Si alloy target (bulk resistance: 26.0 µΩ·cm). An oxidation resistance test of the film as formed (specific resistivity: 45.9µΩ·cm) showed that its resistivity decreased appreciably to 16.2 µΩ·cm, but the value was still unsatisfactorily high.

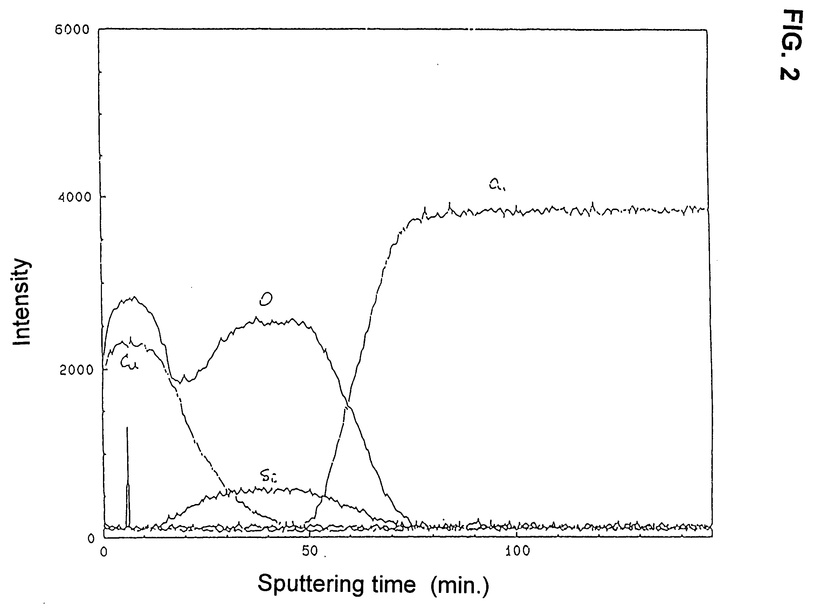

Next, vacuum annealing was performed in the same manner as described in Example 1-1. The resistivity that had been 45.9µΩ·cm immediately after the film formation was now 45.2 µΩ·cm, indicating that the treatment had little resistivity-reducing effect. The vacuum annealed film was then subjected to the oxidation treatment (in air at 450°C for one hour) of Example 1-1. The resistivity lowered to 6.1 µΩ·cm, and the film showed oxidation resistance under very severe conditions. FIG. 2 shows the result of an analysis of the "vacuum annealed and oxidized" film by AES scanned in the depth direction from the film surface. Diffusion of Si into the surface layer and the formation of an alloy oxide layer are observed. The decrease in resistivity after the oxidation treatment implies that the Si diffusion into the surface layer and the formation of the alloy oxide layer were insufficient at the stage after the vacuum annealing alone as compared with the state of FIG. 2.

### (Example 2-2: small amount of Si)

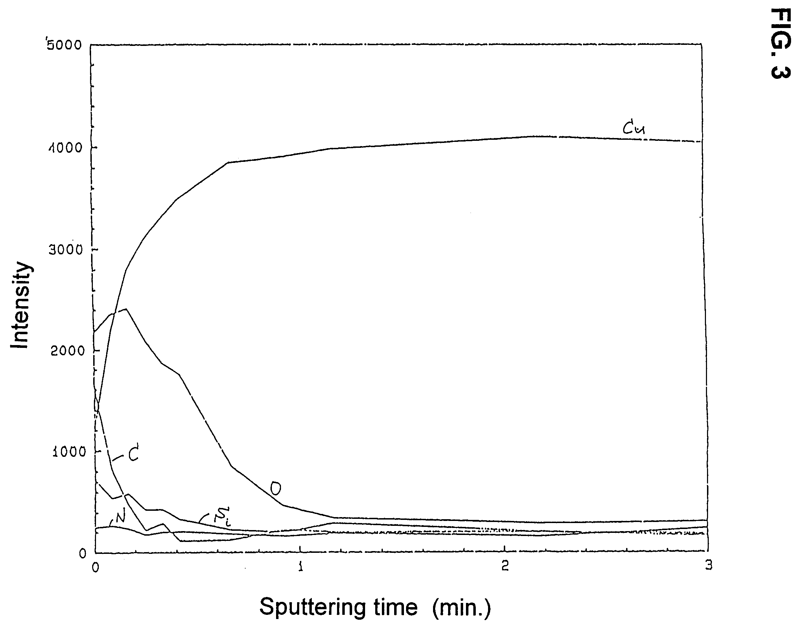

A copper alloy wiring layer with an Si content of 1.0 at% was formed on a substrate using a Cu-0.99 at% Si alloy target (bulk resistance: 3.7µΩ·cm). The film as formed (specific resistivity: 9.8µΩ·cm) was heat treated (N₂ gas-annealed) in 1 atm N₂ gas atmosphere at (a) 300 °C and (b) 450 °C for one hour each. The resistivity decreased to (a) 4.4 and (b) 4.5 µΩ·cm, respectively. FIG. 3 shows the result of an analysis by AES of the film annealed in N₂ gas at 450°C scanned in the depth direction from the film surface. Diffusion of Si into the surface layer and the formation of an alloy oxide layer are observed. This N₂ gas-annealed film (a) was tested for oxidation resistance and it was found to possess oxidation resistance, with the resistivity fairly improved to 2.5µΩ·cm.

### (Example 3: both Al and Si)

A copper alloy wiring layer containing 2.1 at% Al and 2.2 at% Si was formed on a substrate using a Cu-2.1 at% Al-2.2 at% Si alloy target (bulk resistance: 7.7µΩ·cm). The film as formed (specific resistivity: 15.4µΩ·cm) was heat treated (N₂ gas annealed) in 1 atm N₂ gas at (a) 300°C and (b) 450 °C for one hour each. The resistivity decreased, respectively, to (a) 13.9 and (b) 12.5 µΩ·cm.

The N₂ gas-annealed film (a) was evaluated by an oxidation resistance test, when it was found to possess oxidation resistance, with the resistivity rather improved to 8.7 µΩ·cm.

### (Comparative Example 1: pure copper)

A wiring layer of pure copper was formed on a substrate using a pure copper target (bulk resistance: 1.9 µΩ·cm). The oxidation resistance of this copper wiring layer was evaluated by an oxidation resistance test, when the film formed by sputtering was oxidized and peeled off from the substrate.

Next, the film layer was subjected to (a) the same vacuum annealing as used in Example 1-1, (b) vacuum annealing at 700°C , (c) N₂ gas-annealing at 300 °C for one hour, and (d) N₂ gas-annealing at 450 °C for one hour. The specific resistivity of the film as sputtered, being 2.9 µΩ·cm, changed to (a) 2.3, (b) 2.1, (c) 2.0, and (d) 2.1 µΩ·cm, respectively.

Attempts were made to evaluate the vacuum annealed film and the N₂ gas-annealed film by an oxidation resistance test. Like the film as formed, the sputtered film peeled off from the substrate upon oxidation, and even the vacuum annealing or N₂ gas annealing still leaves a problem of insufficient thermal resistance unsolved.

### (Comparative Example 2-1: Cu-Ti)

A wiring layer of a copper alloy containing 15.0 at% Ti was formed on a substrate using a Cu-13.5 at% Ti alloy target (bulk resistance: 23.5µΩ·cm). The film as formed (specific resistivity: 148µΩ·cm) was evaluated by an oxidation resistance test. The resistivity substantially deteriorated to 444µΩ·cm, indicating that the film yet to be treated was not resistant to oxidation.

To impart oxidation resistance, the film as formed was vacuum annealed in the manner described in Example 1-1, when the specific resistivity decreased to 52.3µΩ·cm. An oxidation resistance test conducted to evaluate the vacuum annealed film gave a specific resistivity of 49.9 µΩ·cm, a still undesirably high value, although the test caused no deterioration and the film was oxidation-resistant to some degree.

Next, the film as formed (specific resistivity: 148 µΩ·cm) was heat treated in an N₂ + H₂ (50%) mixed gas atmosphere at 100 Pa and at 400 °C for one hour so as to nitride it. This treatment reduced the resistivity of the wiring material to 48.8 µΩ·cm. An oxidation resistance test conducted for the evaluation of the nitrided film rather improved the resistivity to 18.4µΩ·cm. Thus it was found that the film formed by nitriding is unstable and its properties are changed by subsequent oxidation treatment and that mere oxidation does not fully improve the resistivity.

### (Comparative Example 2-2: Cu-Ti)

A Cu-Ti alloy wiring layer on a substrate was treated under the same conditions as used in comparative Example 2-1 with the exception that the temperature of the treatment with the N₂ + H₂ (50%) mixed gas changed to 700°C . This treatment sharply decreased the specific resistivity to 4.0 µΩ·cm, compared with the value (48.8 µΩ·cm) when treated at 400°C, or a level high enough to justify the use of the film layer as a high-integration wiring material. Evaluation of the nitrided film through an oxidation resistance test proved that, with the resistivity unchanged at 4.0 µΩ·cm, the film treated by nitriding is stable, does not undergo changes in the properties by subsequent oxidation treatment, and is usable as a high-integration wiring material. Here, in order to determine the effect of the heat treatment alone without the influence of an atmosphere, the film as formed was vacuum annealed at 700 °C . The effectiveness of nitriding was confirmed with a resistivity of 11.9µΩ·cm (again 11.9 µΩ·cm upon an oxidation resistance test).

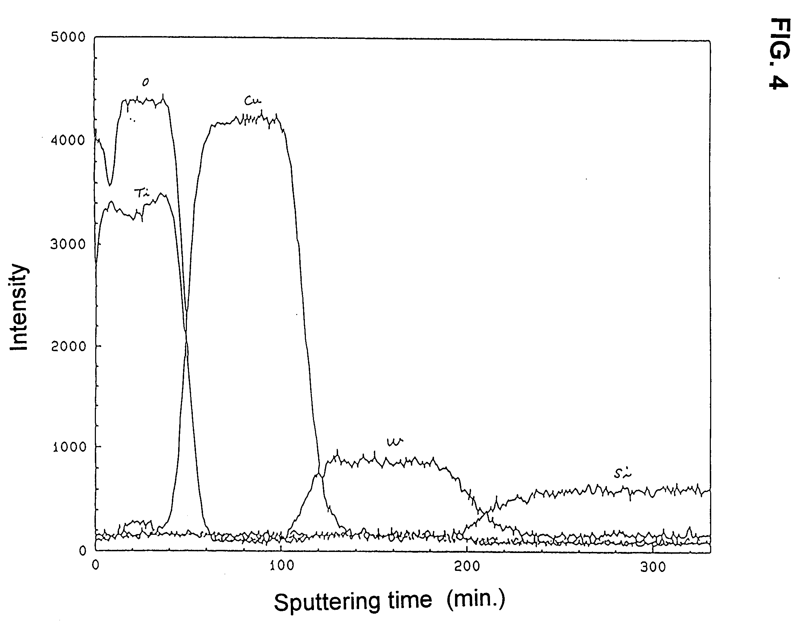

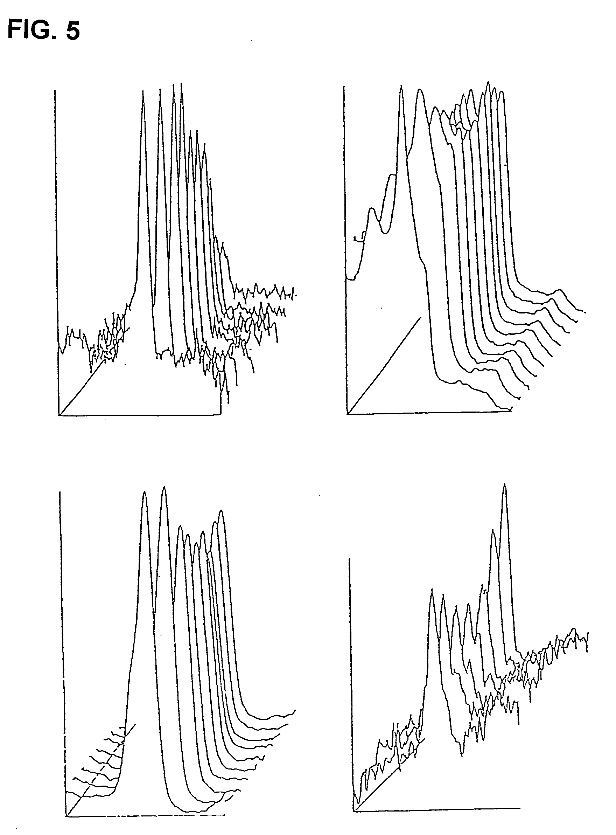

FIG. 4 shows the results of an analysis by AES of the nitrided film scanned in the depth direction from the surface. Since the peak of nitrogen was superposed undiscernibly with that of Ti, the results of an analysis by X-ray photo-electron spectroscopy (XPS) are added as represented in FIG. 5. These results indicate that Ti in the vicinity of the film surface mostly forms an oxide, while a part forms a nitride.

Thus, with the Cu-Ti alloy wiring layer, vacuum annealing did not give a desirable resistivity, but N₂ + H₂ (50%) mixed gas treatment at 700°C imparted properties that make the layer suitable as a high-integration wiring material. It is a problem as noted above, however, that the latter requires the high temperature of as high as 700°C .

### [ADVANTAGES OF THE INVENTION]

1. Semiconductor devices are obtained which, despite the use of finer wirings with increasing degrees of integration, do not have increased wiring resistance.
2. Since the wiring resistance (hence the current density) does not increase, there is no electromigration (EM) problem.
3. The difference in thermal expansion between the wiring material and the substrate material is small enough to preclude stress migration (SM).
4. The wirings being excellently resistant to EM and SM, the semiconductor devices can maintain and enhance their reliability.
5. A copper wiring barrier layer is realized which is excellent in oxidation resistance, does not react with films of Si and SiO₂, and can be formed by self-alignment at low temperature. It thus improves the performance of semiconductor devices.
6. Almost all the process steps and materials currently in use for the manufacture of aluminum-wired semiconductors can be utilized. Consequently, the increase in cost of manufacturing semiconductor devices that otherwise results from changes of wiring materials can be kept low, and the initial (construction) cost sharply reduced.

## Claims

1. A semiconductor device wherein thin film wirings on a substrate is formed of a copper alloy which consists of 0.02 to 20 atomic percent of aluminum or 0.02 to 20 atomic percent of silicon or both and the balance copper and unavoidable impurities.

2. A semiconductor device according to claim 1 wherein an oxide film layer of the copper alloy is formed on the wiring surface.

3. A semiconductor device according to claim 1 or 2 wherein a preferentially selected oxide layer of aluminum or silicon or both is formed.

4. A semiconductor device according to claim 1, 2, or 3 wherein the specific resistivity of the copper alloy wirings is 10 µΩ·cm or less.

5. A method of manufacturing semiconductor devices comprising the steps of:
forming thin film wirings on a substrate from a copper alloy consisting of 0.02 to 20 atomic percent of aluminum or 0.02 to 20 atomic percent of silicon or both and the balance copper and unavoidable impurities, and
then heat treating the thin film wirings at or below 500 °C .

6. A sputter target for forming thin film wirings of semiconductors which consists of 0.02 to 20 atomic percent of aluminum or 0.02 to 20 atomic percent of silicon or both and the balance copper and unavoidable impurities.

7. A method of manufacturing semiconductor devices comprising the steps of:
forming thin film wirings on a substrate by sputtering a sputter target of a copper alloy which consists of 0.02 to 20 atomic percent of aluminum or 0.02 to 20 atomic percent of silicon or both and the balance copper and unavoidable impurities, and
then forming an oxide film on the thin film wiring surface.
